# EUROPÄISCHE PATENTANMELDUNG

(11) **EP 4 676 209 A1**
(43) Veröffentlichungstag der Anmeldung: **07.01.2026**
(21) Anmeldenummer: 24176022.2
(22) Anmeldetag: 15.05.2024
(51) Int. Cl.: H10N 60/00, H01L 29/778, H01L 29/82

(54) **HOCHSTROM-DRIFT-TRANSISTOR**

(71) Anmelder: ANDRÄ, Jürgen, 38700 Corenc (FR)
(72) Erfinder: ANDRÄ, Jürgen, 38700 Corenc (FR)
(74) Vertreter: Burger, Markus

(57) **Zusammenfassung**

Ein Hochstrom-Drift-Transistor (HSDT) mit kleinen Verlusten soll dadurch realisiert werden, dass Elektronen mit Energien E<E_{F}-k_{B}T (E_{F}=Fermi-Energie, k_{B}=Boltzmann-Konstante, T=Temperatur) eines völlig gefüllten Leitungsbands eines zweidimensionalen Elektronengases (2DEG) der Dimensionen Lₓ·L_{y} in der x-y-Ebene einem Magnetfeld B_{z} und elektrischen Feldern Eₓ und E_{y} ausgesetzt werden, was sie alle auf eine Driftgeschwindigkeit v_{D} in der x-y-Ebene zwingen soll. Der resultierende elektrische Driftstrom kann sehr groß werden, da er widerstandlos ist, denn die beteiligten Elektronen können nicht durch Streuung an Fehlstellen, Verunreinigungen oder Phononen gestört werden, da alle möglichen Endzustände dieser Prozesse durch andere Elektronen besetzt sind. Damit kann der HSDT sehr große elektrische Leistungen im kW-Bereich steuern.

## Beschreibung

Es ist bekannt, dass in der Leistungselektronik High Electron Mobility Transistoren (HEMT) [1] zum Einsatz kommen, die mit hohen "source"-"drain"-Spannungen U_{sd} (beispielsweise 600 V), aber kleinen Strömen im Ampère-Bereich elektrische Leistungen im Sub-Kilowatt-Bereich regeln können, in denen allerdings hohe thermische Verluste von einigen Hundert Watt auftreten.

Die vorliegende Erfindung betrifft einen Hochstrom-Drift-Transistor (HSDT), der beispielsweise schon bei sicheren U_{sd}=48 V einen Strom von 160 A, d.h. eine elektrische Leistung bis 7.68 kW steuern kann, und dabei nur einen thermischen Verlust bis 16 W erleidet.

Mit den Patentanmeldungen EP 22020256.8-1212/4287281 mit dem Zeichen andromed 01, eingereicht am 1.6.2022 beim Europäischen Patentamt, und PCT/EP2023/063426 mit Zeichen ANDROMEDPCT, eingereicht am 18.5. 2023 beim European Patent Office, und den jeweils nachgereichten Verbesserungen wurden die Grundlagen für die Entwicklung neuartiger elektronischer Bauelemente mit sehr kleinen Verlusten geschaffen.

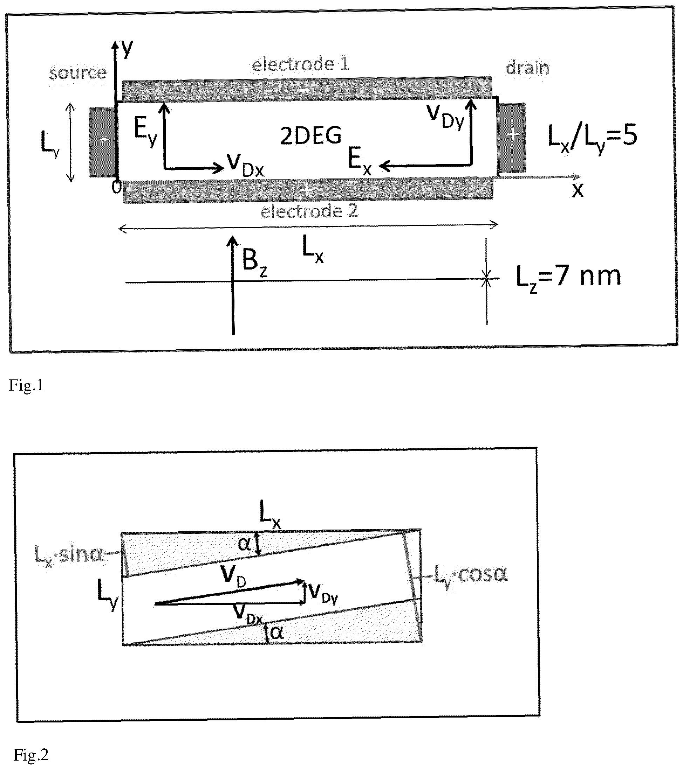

Die Aufgabe der obigen Patentanmeldungen ist die Nutzbarmachung der in den obigen Patentanmeldungen definierten Edel-Elektronen mit Energien E₁≤E≤E_{F}-k_{B}T in einem 2-Dimensionalen Freien Elektronen Gas (2DFEG) für die verlustfreie elektrische Stromleitung durch das 2DFEG. Dabei sind E₁ der quantenmechanische Grundzustand des 2-Dimensionalen Elektronen Gases (2DEG), E_{F} die Fermi-Energie, k_{B} die Boltzmann Konstante und T die Temperatur. Diese Edel-Elektronen sind störungsfrei, da die quantenmechanischen Endzustände aller möglichen Störprozesse in einem vollgefüllten Leitungsband eines 2DFEG durch andere Elektronen besetzt sind und somit die Störprozesse nicht stattfinden können [2]. Sie erlauben dennoch verlustfreie Elektronenströme in x-Richtung, wenn ihnen in gekreuzten elektrischen Feld E_{y}=U_{y}/L_{y}in y-Richtung und magnetischem Feld B_{z} in z-Richtung eine Drift-Geschwindigkeit v_{Dx}=E_{y}/B_{z} in x-Richtung aufgeprägt wird. Für eine Flächendichte n_{edel} der Edel-Elektronen in einem 2DEG in der x-y-Ebene der Dimensionen Lₓ und L_{y} liefert diese Drift-Geschwindigkeit den verlustfreien Elektronenfluss J_{Dx}=n_{edel}·e·v_{Dx}·L_{y}=n_{edel}·e·U_{y}/B_{z} durch das 2DFEG von der "source"-Elektrode bei x=0 zur "drain"-Elektrode bei x=Lₓ (siehe Fig. 1). Da der Elektronenfluss J_{Dx} verlustfrei ist, wird er als Super-Elektronenfluss J_{Dxsuper} oder Super-Strom bezeichnet. Für n_{edel}=1·10¹³ cm⁻² ergibt das beispielsweise bei U_{y}=10 V und B_{z}=0.01 Tesla einen Super-Elektronen-Drift-Strom von beachtlichen 16 A. Dies setzt allerdings voraus, dass keine anderen elektrischen Felder als E_{y}=U_{y}/L_{y} im 2DEG vorhanden sind. D.h. es darf keine "source"-"drain"-Spannung Uₓ=U_{sd} angelegt werden, denn dann würde ja ein störendes elektrisches Feld Eₓ=Uₓ/Lₓ im 2DFEG auftreten. Der Problematik des Auftretens eines Feldes Eₓ im 2DFEG wurde in den obigen Patentanmeldungen nicht die nötige Aufmerksamkeit gewidmet.

Aufgabe der Erfindung ist es deshalb, die verlustfreien Eigenschaften der Edelelektronen für den Betrieb elektronischer 2DFEG-Bauelemente, hier speziell eines HSDT mit U_{y}≠0 und Uₓ=U_{sd}≠0 nutzbar zu machen, wobei der Vorteil sehr hoher Ströme bei sehr geringen Gesamtverlusten voll zum Tragen kommt.

### Beschreibung der Zeichnungen:

Fig.1 Eine Spannung Uₓ≠0 erzeugt das Feld Eₓ im 2DEG, das zusammen mit B_{z} eine Driftgeschwindigkeit v_{Dy} in y-Richtung bewirkt. Daraus resultiert ein Super-Elektronenfluss J_{Dysuper}, der dem normalen Elektronenfluss J_{yn} von Elektrode 1 zu Elektrode 2 entgegengesetzt ist.
Fig.2 Wenn Uₓ≠0 wird, dreht sich die Drift-Geschwindigkeit um den Winkel α zum Vektor v_{D}. Dadurch erreichen driftende Elektronen nur noch mit dem Querschnitt L_{y}·cosα die "drain"-Elektrode, wovon nur der Bruchteil L_{y}·cosα-Lₓ·sinα aus der "source"-Elektrode stammen (weisses Band) und der Bruchteil Lₓ·sinα/L_{y}·cosα (gelbes Dreieck) aus der Elektrode 2 gezogen wird. Entsprechend driften auch Elektronen mit dem Querschnitt Lₓ·sinα zur Elektrode 1.
Fig.3 J_{Dxsuper}(grün) und J_{Dysuper}(fuchsia) als Funktion des linear ansteigenden U_{y}(blau). Mit steigendem J_{Dxsuper} nimmt Uₓ(rot) am Drift-Transistor ab. J_{Dxs} steht für J_{Dxsuper} und J_{Dys} für J_{Dysuper}.
Fig.4 Wie Fig.3, aber für U_{ymax}=400 V. J_{Dxs} steht für J_{Dxsuper}und J_{Dys} für J_{Dysuper}.
Fig.5 J_{Dxsuper} (grün) und J_{Dysuper} (fuchsia) als Funktion des linear ansteigenden n_{edel} bei konstantem U_{y}=U_{y0}(blau). Mit steigendem J_{Dxsuper} nimmt Uₓ (rot) am Drift-Transistor ab.J_{Dxs} steht für J_{Dxsuper} und J_{Dys} für J_{Dysuper}.
Im Folgenden wird auf die Zeichnungen und Fig. 1 - 5 Bezug genommen.

Sobald Uₓ≠0 wird, entsteht ein elektrisches Feld Eₓ=Uₓ/Lₓ im 2DFEG, das zusammen mit dem magnetischen Feld B_{z} in z-Richtung zu einer Drift-Geschwindigkeit v_{Dy} in y-Richtung in Fig.1 führt. Daraus resultiert ein Super-Elektronenfluss J_{Dysuper} in y-Richtung, der dem normal-leitenden Elektronenfluss J_{yn}=nₗₑᵢₜ·e·µ·U_{y}·Lₓ/L_{y} von Elektrode 1 (negativ) zu Elektrode 2 (positiv) entgegengesetzt ist. Dabei sind nₗₑᵢₜ die Flächendichte der Leitungselektronen mit Energien zwischen E=E_{F}±k_{B}T, µ die Beweglichkeit dieser Leitungselektronen und U_{y} die Spannung zwischen den Elektroden 1 und 2. Dieser Strom J_{yn} ist unabhängig von B_{z}, da die mittlere Stosszeit τ<10⁻⁴·f⁻¹ sehr viel kleiner als eine Zyklotron-Periode f⁻¹ ist.

Die Drift-Vektoren **v**_{D}=(**E**x**B**)/B² der aufeinander senkrecht stehenden elektrischen Felder **E**_{y} und **E**ₓ addieren sich zu einem schräg durch das 2DFEG laufenden Gesamt-Drift-Vektor **v**_{D}=**v**_{Dx}+**v**_{Dy} in Fig.2. Randfeld-Effekte, z.B. in den Ecken des 2DEG, werden dabei vernachlässigt. Mit Uₓ≠0 dreht sich die Drift-Geschwindigkeit aus der x-Richtung um den Winkel α zum Vektor **v**_{D}. Dadurch erreichen driftende Elektronen nur noch mit dem Querschnitt L_{y}·cosα die "drain"-Elektrode, wovon nur der Bruchteil L_{y}·cosα-Lₓ·sinα aus der "source"-Elektrode stammen (weisses Band) und der Bruchteil Lₓ·sinα/L_{y}·cosα (gelbes Dreieck) der Elektronen aus der Elektrode 2. Der Winkel α ergibt sich aus α=arctan(v_{Dy}/v_{Dx}), wobei v_{Dy}/v_{Dx}=(Uₓ/U_{y})·(L_{y}/Lₓ) gilt. Daraus ergibt sich für Uₓ≠0 und U_{y}=0 α=π/2, d.h. ein reiner Superstrom nur in y-Richtung, und für Uₓ=0 und U_{y}≠0 α=0, d.h. ein reiner Elektronenfluss nur in x-Richtung. Das Verhältnis Uₓ/U_{y} führt also zu einem geometrischen Umlenken des Super-Elektronenflusses im 2DFEG aus der x-Richtung zu Winkeln α>0. Bei Uₓ=U_{y} verschwindet das weisse Band in Fig.2 oder der direkte Super-Elektronenfluss von der "source"-Elektrode zur "drain"-Elektrode. Im Umkehrschluss heisst das, dass Uₓ<U_{y} bleiben muss, um einen direkten Super-Elektronenfluss von der "source"-Elektrode zur "drain"-Elektrode zu erlauben.

Die Konsequenzen für den Betrieb eines Drift-Transistors können zum Beispiel in einer Serienschaltung eines Drift-Transistors in x-Richtung gefolgt von einem Last-Widerstand R_{Lx}, beide zwischen den Spannungen 0 an der "source"-Elektrode und U₀ am entfernten Ende des Last-Widerstands R_{Lx}, beschrieben werden. Da der Spannungsabfall an R_{Lx} gleich ΔU=J_{Dxsuper}·R_{Lx} wird, wird die Spannung Uₓ am Drift-Transistor Uₓ=U₀-ΔU. Da J_{Dxsuper} von U_{y} abhängt, kann beispielsweise bei einem zeitabhängigen Verbraucher R_{Lx}(t) der J_{Dxsuper} des Drift-Transistors mit U_{y} so geregelt werden, dass Uₓ=0 am Drift-Transistor und damit sein optimaler Betrieb mit α=0 immer gewährleistet ist.

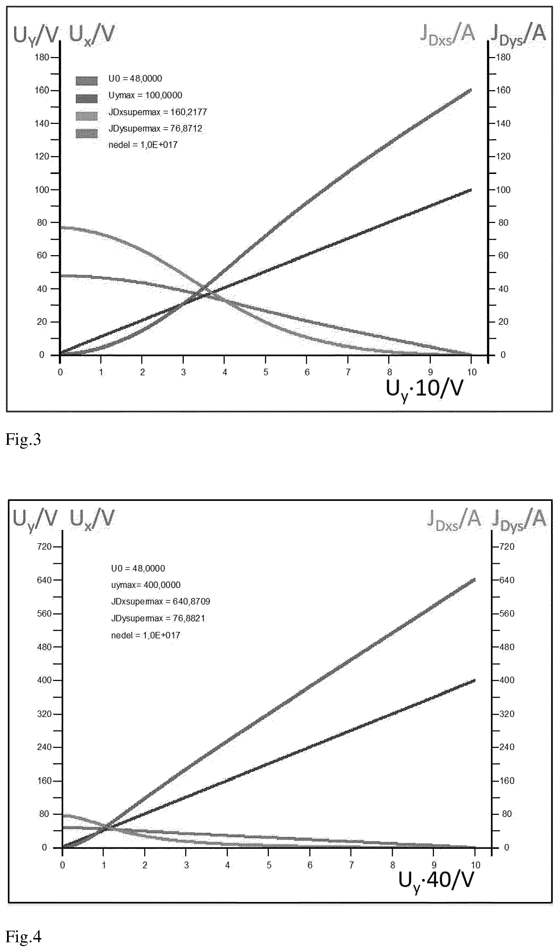

Soll dagegen die an einem konstanten R_{Lx} abgegebene Leistung in der vorher beschriebenen Serienschaltung mit U_{y} gesteuert werden, muss notwendigerweise Uₓ≠0 in Kauf genommen werden. Dies hat massive Störungen der Steuerung von J_{Dxsuper} durch U_{y} zur Folge. Dabei sei beispielsweise R_{Lx} so gewählt, dass bei U_{ymax} gerade ein Elektronenfluss J_{Dxsupermax} generiert wird, der Uₓ=U₀-R_{Lx}·J_{Dxsupermax} zu 0 macht. Als Beispiel sind die Entwicklungen der J_{Dxsuper}, J_{Dysuper} und Uₓ als Funktion des linear ansteigenden U_{y} in Fig.3 mit den angegebenen Parametern dargestellt.

Für U_{y}=0 und damit auch J_{Dxsuper}=0 wird Uₓ=U₀, was einen maximalen Super-Elektronenfluss J_{Dysupermax} von Elektrode 2 zur Elektrode 1 bewirkt. Dieser Elektronenfluss, der dem vom U_{y}-Netzgerät erzeugten Elektronenfluss J_{yn} entgegengesetzt ist, muss vom U_{y}-Netzgerät absorbiert werden, um U_{y}=0 zu gewährleisten. Er kann aber auch in einem zweiten aktiven oder passiven Lastwiderstand R_{Ly} in Serie mit dem U_{y}-Netzgerät nutzbringend verwertet werden. In Anbetracht der Vorzeichen der Elektronenflüsse J_{Dysuper} und J_{yn} entspricht diese Absorption einer Rückgewinnung des von Uₓ verursachten Super-Elektronenflusses J_{Dysuper}. Sobald U_{y}(blau) linear ansteigt, reduziert sich der Winkel α, so dass sich J_{Dysuper}(fuchsia) reduziert und sich stattdessen ein endlicher Super-Elektronenfluss J_{Dxsuper}(grün) entwickelt. Dieser J_{Dxsuper} hat auch zur Folge, dass Uₓ(rot) am Drift-Transistor abnimmt, denn Uₓ=U₀-J_{Dxsuper}·R_{Lx}. In Fig.3 ist diese Entwicklung deutlich zu erkennen, die zu einer starken Nichtlinearität von J_{Dxsuper} als Funktion von U_{y} führt. Dies ändert sich erst ab U_{y}>Uₓ, wo sich J_{Dxsuper} einer linearen Abhängigkeit von U_{y} annähert. Daraus ist zu schliessen, dass der Drift-Transistor in Serie mit einem Lastwiderstand R_{Lx} bei Steuerung durch U_{y} vor allem im Bereich U_{y}>Uₓ sinnvoll eingesetzt werden kann. Dieser Bereich U_{y}>Uₓ entspricht in Fig.2 einer endlichen Breite des weissen Bandes direkt von der "source"- zur "drain"-Elektrode.

Das wird für das Beispiel Uₓₘₐₓ=400 V und U₀=48 V in Fig.4 sehr deutlich, wo U_{y}>Uₓ schon ab U_{y}=60 V gut ausgeprägt ist. Die lineare Steuerung mit U_{y} von etwa 60 V bis 400 V ermöglicht für dieses Beispiel den J_{Dxsuper} von 96 A bis 640 A. Das entspricht bei U_{ymax}=U_{y0}=400 V einer maximal an R_{Lx} abgegebenen Leistung von 30.72 kW. Dies sind allerdings Grenzwerte, die nicht überschritten werden können, da die maximale v_{Dx}-Driftgeschwindigkeit relativistisch betrachtet den Wert v_{Dxmax}=2·10⁸ m/s nicht überschreiten kann/soll. Aus v_{Dxmax}=E_{y}/B_{z} folgt bei B_{z}=0.01 Tesla eine maximal erlaubte Feldstärke E_{ymax}=2·10⁶ V/m. Das bedeutet, dass bei U_{y}=400 V eine relativistisch bedingte Mindestbreite L_{yminrel}=200 µm erforderlich wird.

Je nach Spannungsfestigkeit des 2DEG und unter Berücksichtigung von E_{ymax} können die Figs.3 und 4 zu noch höheren Spannungen und damit auch zu höheren Super-Strömen skaliert werden. Wenn die starken Nichtlinearitäten bei kleinen U_{y}<0.15·U_{ymax} akzeptiert werden können, lässt sich der Drift-Transistor also sehr gut mit U_{y} steuern, und das sogar linear. Voraussetzung dafür ist aber, dass sich der starke J_{Dysuper}=n_{edel}·e·U₀/B_{z} Super-Elektronenfluss tatsächlich vom U_{y}-Netzgerät absorbieren lässt oder sogar nutzbringend verwertet werden kann.

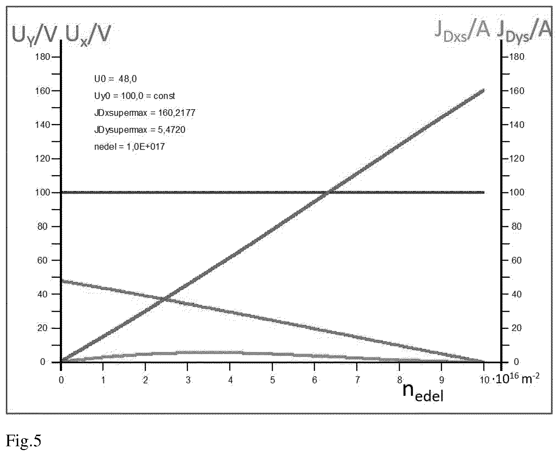

Alternativ zur Steuerung von J_{Dxsuper} durch U_{y} bietet sich beim Drift-Transistor auch an, eine Gate-Steuerung von J_{Dxsuper} mit der Gate-Spannung U_{G} wie bei HEMT's [2] zu verwenden. Diese Gate-Spannung U_{G} steuert nₑ und damit auch n_{edel}. Diese Art der Steuerung hat den grossen Vorteil, dass bei nₑ=0 und n_{edel}=0 nicht nur J_{Dxsuper}=0 wird, sondern auch J_{Dysuper}=0 wird. Dies ist sofort im Beispiel in Fig.5 zu erkennen, in der J_{Dxsuper}(grün) bei konstantem U_{y0}(blau) als Funktion einer linearen Entwicklung von n_{edel} dargestellt ist. Dabei wird J_{Dysuper}(fuchsia) tatsächlich J_{Dysuper}=0 bei n_{edel}=0, steigt dann langsam an bis zu einem Wert J_{Dysuperrmax} und nimmt dann wieder ab bis zu J_{Dysuper}=0 bei n_{edel}=10¹⁷m⁻², dem angenommenen Maximalwert von n_{edel} in dem 2DFEG. Im Vergleich zu Fign.3 und 4 ist das ein bedeutender Vorteil, denn das U_{y0}-Netzgerät muss im Beispiel der Fig.5 trotz des ungünstigen Verhältnisses U₀/U_{y0}=0.48 nur noch J_{Dysupermax}=5.47 A an Stelle der J_{Dysupermax}=76,9 A in Fig.3 absorbieren. Das geringe J_{Dysuper} hat auch zur Folge, dass J_{Dxsuper}(grün) fast linear als Funktion von n_{edel} ansteigt, was sich auch im fast linearen Abfall von Uₓ(rot) zeigt. Im praktischen Betrieb wird dieser fast lineare Anstieg von J_{Dxsuper} aber noch durch die Nichtlinearitäten der Funktion n_{edel}=f(U_{G}) überdeckt, wie sie bei Steuerung von HEMT's durch U_{G} auftreten.

Damit wird der Einsatz eines HSDT dem Einsatz von HEMT's vergleichbar. Der grosse Vorteil des HSDT ist aber sein widerstandsloser Stromtransport, der deshalb gegenüber HEMT's viel grössere elektrische Leistungen möglich macht. Für das Beispiel der Fig.5 wird die maximale an R_{Lx} abgegebene Leistung W_{Lmax}=7.68 kW bei einem maximalen thermischen Verlust W_{yloss}= nₗₑᵢₜ·e·µ·U_{y}·(Lₓ/L_{y})·U_{y} von nur 16 W, der durch den Normalstrom J_{yn}=nₗₑₜ·e·µ·U_{y}·Lₓ/L_{y} zwecks Erzeugung des elektrischen E_{y}-Feldes im 2DFEG verursacht wird. Da für dieses Beispiel U_{y}=const=U_{y0} gilt und nₗₑᵢₜ=n_{edel} angenommen wird, nimmt der thermische Verlust W_{yloss}proportional zu n_{edel} von null ausgehend bis zum Maximalwert von 16 W zu. Bei Beibehaltung des Verhältnisses U₀/U_{y0} lässt sich Fig.5 zu höheren oder kleineren Spannungen und zu höheren und oder kleineren Strömen skalieren. Aber auch andere konstante Verhältnisse U₀/U_{y0} sowie variable Verhältnisse U₀/U_{y0} können verwendet werden. So wird beispielsweise bei U₀=48 V, U_{y0}=U_{ymax}=400 V in Fign.4 oder 5 die Regelung einer elektrischen Leistung bis 30.72 kW möglich, bei welcher der HSDT nur einen thermischen Verlust bis 256 W erleidet.

Bisher wurde nur die einfache Serienschaltung in x-Richtung eines Drift-Transistors gefolgt von einem Last-Widerstand R_{Lx} zwischen 0 und U₀ Volt behandelt. Mit den Eigenschaften des Drift-Transistors können komplexere Schalt-Schemata mit einem oder mehreren Drift-Transistoren in Betracht gezogen werden. Diese Schalt-Schemata schliessen dann auch die Kombinationen eines oder mehrerer Drift-Transistoren mit allen bisher bekannten elektronischen Bauelementen ein.

Besonders vielversprechend ist dabei die Parallelschaltung von q HSDT, was sowohl die elektrische Gesamtleistung als auch den thermischen Gesamtverlust mit dem Faktor q multipliziert. Für q=10 ergibt das dann für das Beispiel U₀=48 V, U_{y0}=100 V die elektrische Gesamtleistung bis 76.8 kW bei einem thermischen Gesamtverlust bis nur 160 W. Dieses Ergebnis legt nahe, von vornherein eine Halbleiter-Heterostruktur mit q-fachem Übergitter aus q in z-Richtung übereinander geschichteten, rechteckigen Quantentrögen für q voneinander getrennte 2DEG's mit entsprechenden Gate-Elektroden in einem qHSDT zu produzieren. Ein solcher qHSDT ermöglicht die q-fache elektrische Gesamtleistung bei nur q-fachem thermischen Gesamtverlust eines einzelnen HSDT.

### Referenzen

[1] "High-electron-mobility transistor" in Wikipedia
[2] R. Gross und A. Marx, "Festkörperphysik", Oldenbourg Verlag, 2012, ISBN 978-3-486-712294-0, Seite 296.
[3] H.J. Andrä, "Neuer Hochstrom-Drift-Transistor mit kleinen Verlusten" (Mai 2024), DOI: 10.13140/RG.2.2.12614.08004 und die leicht verbesserte englische Version "New High Current Drift-Transistor with Low Losses" (Mai 2024), DOI: 10. 13140/RG.2.2.31705.94566.

## Patentansprüche

1. Neuer Hochstrom-Drift-Transistor mit kleinen Verlusten, **dadurch gekennzeichnet, dass** die Koexistenz eines elektrischen Feldes **E**_{y} in y-Richtung und eines elektrischen Feldes Eₓ in x-Richtung bei gleichzeitiger Anwesenheit eines magnetischen Feldes B_{z} in z-Richtung in einem Freien 2-Dimensionalen Elektronen Gas (2DFEG) der Dimension Lₓ·L_{y} in der x-y-Ebene zu Driftbewegungen der Edel-Elektronen, die in den Patentanmeldungen EP22020256.8-1212/4287281 und PCT/EP2023/232494 A1 mit ihrer Nutzbarmachung für die verlustfreie Elektronen-Leitung in 2DFEG beschrieben wurden, im 2DFEG mit dem Winkel α relativ zur x-Achse führen, wobei α=arctan(Eₓ/E_{y}) vom Verhältnis Eₓ/E_{y} abhängt, so dass mit dem 2DFEG bei α<arctan(L_{y}/Lₓ) ein Hochstrom-Drift-Transistor (HSDT) mit kleinen Verlusten realisiert werden kann, der die Steuerung hoher elektrischer Leistungen bei kleinen Verlusten ermöglicht.

2. Anspruch nach Anspruch 1, **dadurch gekennzeichnet, dass** bei einem HSDT mit konstanter Flächendichte der Edel-Elektronen n_{edel} und mit der Spannung Uₓ zwischen der "source"-Elektrode bei x=0 und der "drain"-Elektrode bei x=Lₓ der verlustfreie Elektronen-Fluss J_{Dxsuper} von der "source"-Elektrode zur "drain"-Elektrode mit der Spannung U_{y} zwischen den Elektroden an den Rändern des 2DFEG bei y=0 und y=L_{y} gesteuert wird, wobei sich J_{Dxsuper} als Funktion von U_{y} einer linearen Funktion nähert, sobald U_{y}>Uₓ wird.

3. Anspruch nach Ansprüchen 1 und 2, **dadurch gekennzeichnet, dass** die Spannungen Uₓ und U_{y} zu grösseren als auch zu kleineren Werten skaliert werden können, wobei die Steuerung von J_{Dxsuper} mit U_{y} umso linearer über einen grossen Bereich von U_{y} wird je grösser das Verhältnis U_{y}/Uₓ wird.

4. Anspruch nach Ansprüchen 1 bis 3, **dadurch gekennzeichnet, dass** die Flächendichte nₑ aller Elektronen im 2DEG des HSDT und damit auch die Flächendichte n_{edel} der Edel-Elektronen im 2DFEG des HSDT mit einer Gate-Spannung U_{G} wie bei HEMT's (High Electron Mobility Transistor) gesteuert wird, so dass beispielsweise bei konstanter Spannung U_{y}=U_{y0} ein fast linearer Anstieg des verlustfreien Superstroms J_{Dxsuper} als Funktion von n_{edel} erhalten wird, solange U_{y0}≥2·Uₓ bleibt.

5. Anspruch nach Ansprüchen 1 bis 4, **dadurch gekennzeichnet, dass** ein HSDT mit einem grossen, verlustfreien Superstrom J_{Dxsuper} durch die "drain"-Elektrode verwirklicht wird, der mit U_{G} gesteuert und nur von kleinen thermischen Verlusten W_{yloss}=nₗₑᵢₜ(U_{G})·e·µ·U²_{y0}·Lₓ/L_{y}=J_{yn}·U_{y0} und Wₓₗₒₛₛ= nₗₑᵢₜ(U_{G})·e·µ·U²ₓ·L_{y}/Lₓ=Jₓₙ·Uₓ begleitet wird, die durch die normal leitenden Ströme J_{yn} und Jₓₙ durch das 2DEG verursacht werden, welche die Felder **E**_{y} und Eₓ im 2DFEG sicherstellen.

6. Anspruch nach Ansprüchen 1 bis 5, **dadurch gekennzeichnet, dass** der im HSDT von Uₓ verursachte Super-Strom J_{Dysuper}, der dem vom U_{y}-Netzgerät gelieferten Normal-Strom J_{yn} entgegengesetzt ist, in diesem Netzgerät oder in einer anderen elektronischen Schaltung zurückgewonnen wird, so dass durch J_{Dysuper} kein oder nur ein geringer Verlust entsteht.

7. Anspruch nach Ansprüchen 1 bis 6, **dadurch gekennzeichnet, dass** der Super-Strom J_{Dxsuper}im HSDT gleichzeitig von den Variablen U_{y} und U_{G} gesteuert wird.

8. Anspruch nach Ansprüchen 1 bis 7, **dadurch gekennzeichnet, dass** der HSDT als Hochleistungsregler in der Leistungselektronik eingesetzt wird, da beispielsweise in einer Serienschaltung eines HSDT mit in x-Richtung folgendem Lastwiderstand R_{Lx}, beide zusammen zwischen 0 Volt an der "source"-Elektrode und U₀ Volt am entfernten Ende von R_{Lx}, sehr hohe elektrische Leistungen W_{L} im kW-Bereich an R_{Lx} abgegeben werden können, die nur von thermischen Verlusten im W-Bereich begleitet werden.

9. Anspruch nach Ansprüchen 1 bis 8, **dadurch gekennzeichnet, dass** in der im Anspruch 8 definierten Serienschaltung oder in einer ähnlicher Schaltung U_{y}(t) und damit J_{Dxsuper}(U_{y},t) so geregelt werden, dass im Fall eines zeitlich variablen Lastwiderstands R_{Lx}(t) immer Uₓ=U₀-J_{DXsuper}(U_{y},t)·R_{Lx}(t)=0 wird, und somit immer die maximale elektrische Leistung W_{L}(t)=U₀·J_{Dxsuper}(U_{y},t) an R_{Lx}(t) abgegeben wird.

10. Anspruch nach Ansprüchen 1 bis 9, **dadurch gekennzeichnet, dass** mehrere HSDT miteinander kombiniert und/oder mit anderen, bekannten elektronischen Bauelementen verschaltet werden.

11. Anspruch nach Ansprüchen 1 bis 10, **dadurch gekennzeichnet, dass** durch Variation des Verhältnisses Eₓ/E_{y}=(Uₓ/U_{y})·(L_{y}/Lₓ) der Winkel α der Richtung der Driftbewegung der Elektronen im 2DFEG relativ zur x-Achse geändert wird, so dass der HSDT als Strom-Richtungs-Weiche als Funktion von Eₓ/E_{y} verwendet werden kann.

12. Anspruch nach Ansprüchen 1 bis 11, **dadurch gekennzeichnet, dass** eine Halbleiter-Heterostruktur mit q-fachem Übergitter aus q in z-Richtung übereinander geschichteten, rechteckigen Quantentrögen mit den notwendigen Gate-Elektroden für q voneinander getrennte 2DEG's in einem qHSDT produziert wird, die alle von gemeinsamen Uₓ, U_{y} oder U_{G} gesteuert werden, so dass ein solcher qHSDT die q-fache elektrische Gesamtleistung bei nur q-fachem thermischen Gesamtverlust eines einzelnen HSDT ermöglicht, wobei U_{G} auch als q-fache Spannungs-Kaskade geschaltet werden kann.

13. Anspruch nach Ansprüchen 1 bis 12, **dadurch gekennzeichnet, dass** rechteckige Geometrien des 2DEG in der x-y-Ebene mit beliebigem Verhältnis Lₓ/L_{y} und andere Geometrien als Rechtecke des 2DEG in der x-y-Ebene möglich sind.

14. Anspruch nach Anspruch 1, **dadurch gekennzeichnet, dass** ein HSDT ohne internes Magnetfeld produziert wird, der es ermöglicht, ein äusseres, unbekanntes Magnetfeld B_{zu} zu bestimmen, indem der bei Uₓ=0 im HSDT von U_{y} erzeugte J_{Dxsuper}=n_{edel}·e·U_{y}/B_{zu} gemessen wird, nachdem vorher n_{edel}·e in einem bekannten, äusseren Magnetfeld B_{zb} in einer Eichmessung bestimmt wurde, wodurch dieser HSDT zu einer hochempfindlichen Hall-Sonde wird, die umso grössere J_{Dxsuper} liefert je kleiner B_{zu} wird und die nur durch die erforderliche, relativistische Mindestbreite L_{yminrel} begrenzt wird.
